# EUROPEAN PATENT SPECIFICATION

(11) **EP 2 537 960 B1**
(45) Date of publication and mention of the grant of the patent: **01.04.2015**
(21) Application number: 11742363.2
(22) Date of filing: 15.02.2011
(51) Int. Cl.: C23F 1/18, C23F 1/26, C23F 1/44, H01L 21/3213, H01L 23/532

(54) **ETCHING SOLUTION and etching method FOR MULTILAYER THIN FILM HAVING COPPER LAYER AND MOLYBDENUM LAYER CONTAINED THEREIN**
ÄTZLÖSUNG und Ätzverfahren FÜR EINE MEHRSCHICHTIGE DÜNNSCHICHT MIT EINER KUPFERSCHICHT UND DARIN ENTHALTENE MOLYBDÄNSCHICHT
SOLUTION D'ATTAQUE et méthode de gravure POUR FILM MINCE MULTICOUCHE COMPRENANT UNE COUCHE DE CUIVRE ET UNE COUCHE DE MOLYBDÈNE

(30) Priority: 15.02.2010 JP 2010030377
(43) Date of publication of application: 26.12.2012
(73) Proprietor: Mitsubishi Gas Chemical Company, Inc., Tokyo 100-8324 (JP)
(72) Inventor: OKABE, Satoshi, Tokyo 125-0051 (JP); NARITA, Kazuyo, Tokyo 125-0051 (JP); MATSUBARA, Masahide, Tokyo 125-0051 (JP); ADANIYA, Tomoyuki, Tokyo 125-0051 (JP); MARUYAMA, Taketo, Tokyo 100-8324 (JP)
(74) Representative: Müller-Boré & Partner Patentanwälte PartG mbB
(86) International application number: PCT/JP2011/053151
(87) International publication number: WO 2011/099624

(56) References cited:
- WO-A1-2009/047203
- JP-A- 1 292 890
- JP-A- 2002 060 980
- JP-A- 2002 302 780
- JP-A- 2006 111 953
- JP-A- 2009 076 601
- KR-A- 20070 055 259
- US-A1- 2004 242 000

## Description

### TECHNICAL FIELD

The present invention relates to an etching solution for a multilayer thin film having a copper layer and a molybdenum layer contained therein. In particular, the etching solution of the present invention is favorably used for etching a multilayer thin film having a copper layer is provided on a molybdenum layer.

### BACKGROUND ART

Heretofore, aluminium or an aluminium alloy has been generally used as the wiring material for display devices such as flat panel displays, etc. However, with growing in size and increasing in resolution of displays, there has occurred a problem of RC delay caused by the characteristics such as the wiring resistance of such aluminium-based wiring materials and uniform panel displaying has tended to be difficult.

Given the situation, the recent tendency is toward investigation of employing copper or copper-based wiring with a material having a lower resistance. However, copper has an advantage in that its resistance is low but, on the other hand, has a problem in that, in use for gate wiring, the adhesiveness between the substrate such as glass or the like and copper is not sufficient and that, in use for source/drain wiring, copper may diffuse into the silicon semiconductor underlayer. Consequently, for preventing these, there has been made an investigation of barrier layer lamination with a metal that has high adhesion to a substrate such as glass, etc. and hardly diffuses into the silicon semiconductor underlayer and additionally has a barrier property; and as the metal, molybdenum (Mo) has become specifically noted.

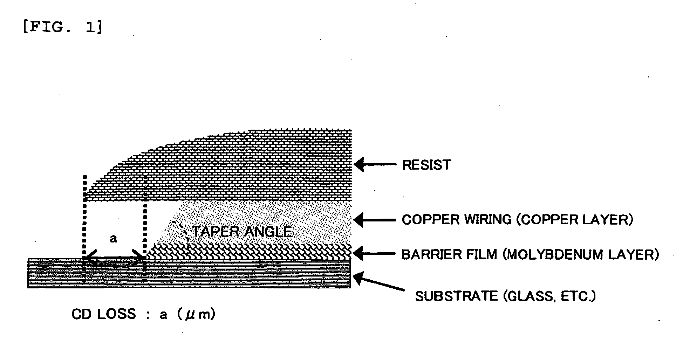

A multilayer film that contains copper or a copper-based copper alloy is formed on a substrate of glass or the like according to a film formation process of a sputtering method or the like, and then processed in an etching process of etching it via a resist serving as a mask to give an electrode pattern. The etching process includes a wet etching mode of using an etching solution and a dry etching mode of using an etching gas of plasma or the like. The etching solution for use in the wet mode is desired to satisfy the following: (i) The processing accuracy is high, (ii) the amount of the etching residue is small, (iii) the etching unevenness level is low, and (iv) an etching performance is stable against dissolution of a metal of a wiring material containing copper which is subjective to etching (a prolonging effect of bath life) ; and in addition to these, for meeting the size enlargement and the resolution enhancement of displays, (v) the wiring configuration formed after etching could fall within a predetermined range, or that is, a good wiring configuration can be obtained. More concretely, the parameters shown in Fig. 1 are desired to be as follows: The angle (taper angle) between the etched face of the copper wiring edge and the substrate is from 30 to 60°, or that is, the angle is a regular taper angle; the distance between the resist edge and the wire edge to be in contact with the barrier layer provided below the wire (CD loss) is not more than 1.2 µm, and preferably not more than 1 µm.

As the etching solution to be used in the etching process for the multilayer film containing copper or a copper-based copper alloy, for example, there have been proposed an etching solution containing at least one selected from a neutral salt, an inorganic acid and an organic acid, and hydrogen peroxide and a hydrogen peroxide stabilizer (for example, Patent Reference 1), an etching solution containing hydrogen peroxide, an organic acid and fluorine (for example, Patent Reference 2), etc.

However, these are all unsatisfactory in point of the wiring profile after etching therewith and, as a result, could not often sufficiently meet the size enlargement and the resolution enhancement of displays. Also, the etching solution disclosed in Patent Reference 2 contains a fluorinated compound, so that it was not thoroughly satisfactory from the viewpoint of environmental measure.

Patent Reference 3 discloses an etching composition and an etching method for metals Cu/Mo, wherein the composition comprises hydrogen peroxide, an amino acid, a pH stabilizer, a fluorine-containing acid and an acidic pH adjuster.

### PRIOR ART DOCUMENTS

### PATENT DOCUMENTS

Patent Reference 1: Japanese Patent No. 4282927
Patent Reference 2: JP-A-2004-193620
Patent Reference 3: WO-2009/047203 A1

### BRIEF DESCRIPTION OF THE DRAWING

[Fig. 1] This is a schematic view of a wiring cross section that has a multilayer thin film containing a copper layer and a molybdenum layer, as etched with the etching solution of the present invention.

### DISCLOSURE OF THE INVENTION

### PROBLEMS TO BE SOLVED BY THE INVENTION

The present invention has been made under the circumstances as above, and its object is to provide an etching solution for a multilayer thin film containing a copper layer and a molybdenum layer, and a method of using it for etching a multilayer thin film containing a copper layer and a molybdenum layer.

### MEANS FOR SOLVING THE PROBLEMS

The present invention relates to an enhing solution and an enhing method as defined in the claims.

### EFFECTS OF THE INVENTION

According to the present invention, there are provided an etching solution which secures, in an etching process for a multilayer thin film containing a copper layer and a molybdenum layer, high processing accuracy, little etching residue and unevenness and a long bath life, and realizes a good wiring profile after etching therewith, and which therefore can meet the requirement of size enlargement and resolution enhancement of displays, and an etching method using it for a multilayer thin film containing a copper layer and a molybdenum layer. According to the etching method, a wiring material that contains a multilayer thin film containing a copper layer and a molybdenum layer can be etched all at a time, and therefore, after etching therewith, a good wiring profile can be realized at high producibility.

### BEST MODES FOR CARRYING OUT THE INVENTION

### [Etching solution for multilayer thin film having copper layer and molybdenum layer contained therein]

The etching solution of the present invention is used for etching of a multilayer thin film having a copper layer and a molybdenum layer contained therein, and it comprises (A) hydrogen peroxide, (B) a fluorine atom-free inorganic acid, (C) an organic acid, (D) an amine compound having a carbon number of from 2 to 10 and having an amino group and a hydroxyl group in a total group number of 2 or more, (E) an azole, and (F) a hydrogen peroxide stabilizer, and has a pH of from 2.5 to 5.

### <<(A) Hydrogen peroxide>>

Hydrogen peroxide which is used in the etching solution of the present invention has a function to oxidize a copper wiring as an oxidizing agent and also has a function to oxidize and dissolve molybdenum. A content of hydrogen peroxide in the etching solution is preferably from 3 to 10 % by mass, and more preferably from 4.5 to 7.5 % by mass. The content of hydrogen peroxide falling within the above range is preferred, the control of hydrogen peroxide is easy, and also as securing a suitable etching rate and facilitating good control of the etching amount. Thus, such is preferable.

### <<(B) Fluorine atom-free inorganic acid>>

The fluorine atom-free inorganic acid which is used in the etching solution of the present invention contributes to the dissolution of copper which has been oxidized with the hydrogen peroxide (A). In the present invention, from the viewpoint of environmental measure, a fluorine atom-free acid is adopted. As the fluorine atom-free inorganic acid, sulfuric acid, nitric acid, hydrochloric acid, phosphoric acid, hypophosphorous acid, carbonic acid, sulfamic acid, boric acid, and the like are selected. These can be used alone or in admixture of a plurality thereof. Above all, sulfuric acid and nitric acid are preferable.

A content of the inorganic acid (B) in the etching solution is preferably from 0.01 to 5 % by mass, and more preferably from 0.01 to 3 % by mass. When the content of the inorganic acid falls within the above range, a suitable etching rate can be secured and a good wiring profile can be obtained after etching.

### <<(C) Organic acid>>

The organic acid which is used in the etching solution of the present invention contributes to the etching of copper and molybdenum and the removal of a residue to be caused due to molybdenum, and the content thereof in the etching solution is preferably from 1 to 15 % by mass, more preferably from 5 to 13 % by mass. When the content of the organic acid falls within the above range, etching of copper and molybdenum and the removal of a residue to be caused due to molybdenum can be sufficiently achieved, and also, a good wiring profile can be obtained after etching. Also, the organic acid functions as a masking agent of a copper ion to be contained in the etching solution after etching and is able to inhibit the decomposition of hydrogen peroxide with copper.

As the organic acid, succinic acid, malic acid, lactic acid, glycolic acid, and malonic acid are selected. These can be used alone or in combination of a plurality thereof.

### <<(D) Amine compound>>

The amine compound which is used in the etching solution of the present invention contributes to the favorable wiring profile after etching and is a compound having a carbon number of from 2 to 10 and having an amino group and a hydroxyl group in a total group number of 2 or more.

As such an amine compound, polyamines such as ethylenediamine, trimethylenediamine, tetramethylenediamine, 1,2-propanediamine, 1,3-propanediamine, N,N-dimethyl-1,3-propanediamine, N,N-diethyl-1,3-propanediamine, 1,3-diaminobutane, 2,3-diaminobutane, pentamethylenediamine, 2,4-diaminopentane, hexamethylenediamine, heptamethylenediamine, octamethylenediamine, nonamethylenediamine, N-methylethylenediamine, N,N-dimethylethylenediamine, trimethylethylenediamine, N-ethylethylenediamine, N,N-diethylethylenediamine, triethylethylenediamine, 1,2,3-triaminopropane, hydrazine, tris(2-aminoethyl)amine, tetra(aminomethyl)methane, diethylenetriamine, triethylenetetramine, tetraethylpentamine, heptaethyleneoctamine, nonaethylenedecamine, diazabicycloundecene, etc.; and alkanolamines such as ethanolamine, N-methylethanolamine, N-methyldiethanolamine, N-ethylethanolamine, N-aminoethylethanolamine, N-propylethanolamine, N-butylethanolamine, diethanolamine, triethanolamine, 1-amino-2-propanol, N-methylisopropanolamine, N-ethylisopropanolamine, N-propylisopropanolamine, 2-aminopropane-1-ol, N-methyl-2-amino-propane-1-ol, N-ethyl-2-amino-propane-1-ol, 1-aminopropane-3-ol, N-methyl-1-aminopropane-3-ol, N-ethyl-1-aminopropane-3-ol, 1-aminobutane-2-ol, N-methyl-1-aminobutane-2-ol, N-ethyl-1-aminobutane-2-ol, 2-aminobutane-1-ol, N-methyl-2-aminobutane-1-ol, N-ethyl-2-aminobutane-1-ol, 3-aminobutane-1-ol, N-methyl-3-aminobutane-1-ol, N-ethyl-3-aminobutane-1-ol, 1-aminobutane-4-ol, N-methyl-1-aminobutane-4-ol, N-ethyl-1-aminobutane-4-ol, 1-amino-2-methylpropane-2-ol, 2-amino-2-methylpropane-1-ol, 1-aminopentane-4-ol, 2-amino-4-methylpentane-1-ol, 2-aminohexane-1-ol, 3-aminoheptane-4-ol, 1-aminooctane-2-ol, 5-aminooctane-4-ol, 1-aminopropanee-2,3-diol, 2-aminopropane-1,3-diol, tris(oxymethyl)aminomethane, 1,2-diaminopropane-3-ol, 1,3-diaminopropane-2-ol, 2-(2-aminoethoxy)ethanol, 2-(2-aminoethylamino)ethanol, diglycolamine, etc. are preferably exemplified. These can be used alone or in combination of a plurality thereof. Of these, ethanolamine, 1-amino-2-propanol, and N,N-diethyl-1,3-propanediamine are especially preferable.

A content of the amine compound in the etching solution of the present invention is preferably from 1 to 10 % by mass, and more preferably from 2 to 7 % by mass. When the content of the amine compound falls within the above range, a good wiring profile can be obtained after etching.

### <<(E) Azole>>

As the azole which is used in the etching solution of the present invention, 1H-benzotriazole, 5-methyl-1H-benzotriazole, 3-amino-1H-triazole, 1H-tetrazole, 5-methyl-1H-tetrazole, 5-phenyl-1H-tetrazole, 5-amino-1H-tetrazole, 1H-imidazole, 1H-benzoimidazole, 1, 3-thiazole, 4-methylthiazole, are selected. Of these, tetrazoles are preferable, and 5-amino-1H-tetrazole is especially preferable.

The content of the azole in the etching solution is preferably from 0.001 to 1% by mass, more preferably from 0.001 to 0.5% by mass. When the content of the azole falls within the above range, a good wiring profile can be obtained while suppressing an increase of CD loss after etching.

### <<(F) Hydrogen peroxide stabilizer>>

The etching solution of the present invention contains a hydrogen peroxide stabilizer. The hydrogen peroxide stabilizer is at least one member selected among phenylurea, allylurea, 1,3-dimethylurea, thiourea, phenylacetamide and phenylethylene glycol. Above all, preferred is phenylurea.

The content of the hydrogen peroxide stabilizer (F) in the etching solution of the present invention is preferably from 0.01 to 0.5% by mass, more preferably from 0.01 to 0.3 % by mass from the viewpoint of sufficiently securing the addition effect thereof.

### <<pH>>

The etching solution of the present invention is required to have a pH of 2.5 to 5. When its pH is less than 2.5, a residue derived from a molybdenum oxide, which is hardly dissolved, which is formed at the time when molybdenum is etched and dissolved, is remained after etching, and as a result, there is a concern that the residue can bring on a lowering of electrical characteristics caused by leak current. Also, when the pH is larger than 5, then the stability of the hydrogen peroxide (A) may lower whereby the etching rate for copper wiring may lower and the bath life of the etching solution may shorten. From such viewpoints, the pH of the etching solution of the present invention is from 2.5 to 5.

### «Copper ion»

For the purpose of enhancing an etching performance from the beginning of use, it is preferable to allow the etching solution of the present invention to contain a copper ion in advance. The copper ion can be contained in the etching solution by adding a copper powder or a copper salt such as copper sulfate, copper nitrate, etc. to the etching solution.

A concentration of the copper ion in the etching solution is preferably 100 ppm or more, and more preferably 200 ppm or more. Also, though an upper limit of the concentration is not restricted so far as the etching performance is not lowered, taking into consideration a bath life and the like, it is preferably not more than 2,000 ppm, and more preferably not more than 1,000 ppm.

### <<Other components>>

The etching solution of the present invention may contain, in addition to the foregoing components (A) to (F), water and other various additives which are usually used in etching solutions, within the range where the effects of the etching solution are not impaired. The water is preferably one from which metal ions or organic impurities, particles, and the like have been removed by means of distillation, ion exchange treatment, filter treatment, adsorption treatment of every kind, or the like, and pure water and ultra-pure water are especially preferable.

### [Etching method of multilayer thin film having copper layer and molybdenum layer contained therein]

The etching method of the present invention is a method for etching a multilayer thin film that contains a copper layer and a molybdenum layer, which comprises a step of bringing a subject to be etched into contact with the etching solution of the present invention. According to the etching method of the present invention, a multilayer thin film containing a copper layer and a molybdenum layer can be etched all at a time to give a good wiring profile after etching.

In the etching method of the present invention, the subject to be etched with the etching solution is one, for example, as shown in Fig. 1, in which a barrier film (molybdenum layer) formed of a molybdenum-based material and a copper wire (copper layer) formed of copper or a copper-based material are laminated in that order on a substrate of glass or the like to form a multilayer thin film containing the copper layer and the molybdenum layer, a resist is further applied thereonto, and a desired pattern mask is transferred on it through exposure and development to form a desired resist pattern thereon. In the present invention, the multilayer thin film containing a copper layer and a molybdenum layer includes an embodiment where the copper layer exists on the molybdenum layer as in Fig. 1, and also an embodiment where the molybdenum layer exists on the copper layer. The multilayer thin film of the type containing a copper layer and a molybdenum layer is favorably used in wiring in display devices such as flat panel displays, etc. Consequently, the subject to be etched in which a copper layer exists on a molybdenum layer is a favorable embodiment from the viewpoint of the industrial applicability thereof.

Not specifically defined, the copper wiring may be formed of copper or a copper-based material, and as the molybdenum-based material to form the barrier film, there may be mentioned molybdenum (Mo) metal, an Mo based alloy, and so on.

The method of bringing the subject to be etched into the etching solution is not specifically defined; and herein employable is a wet etching method, for example, a method of dripping the etching solution onto the subject (sheet-fed spin treatment) or spraying it thereonto, or a method of dipping the subject into the etching solution, etc. In the present invention, preferably employed is the method of dripping the etching solution onto the subject (sheet-fed spin treatment) or spraying it thereonto, or the method of dipping the subject into the etching solution.

The temperature at which the etching solution is used is preferably from 20 to 60°C, more preferably from 30 to 50°C. When the temperature of the etching solution is not lower than 20°C, then the etching rate is not so much lowered and the production efficiency is not extremely lowered. On the other hand, when the temperature is not higher than a boiling point, then the solution composition change could be prevented and the etching condition could be kept constant. Elevating the temperature of the etching solution could increase the etching rate, but in consideration of the object of reducing the composition change of the etching solution, the best treatment temperature may be suitably determined.

In the etching method of the present invention, the hydrogen peroxide (A) contained in the etching solution is consumed by oxidation and dissolution of copper or molybdenum as described above, or the like, and the dissolved copper or molybdenum accelerates the decomposition of hydrogen peroxide. Therefore, there is a concern that a lowering of the performance of the etching solution to be caused due to a lowering of the hydrogen peroxide concentration. In such a case, hydrogen peroxide (A) and the organic acid (B) may be simultaneously or separately added so as to prolong the bath life of the etching solution.

### EXAMPLES

Next, the present invention is described in more detail by reference to the following Examples.

### (Observation of cross section of multilayer thin film having copper layer and molybdenum layer contained therein after etching)

A sample of the etched multilayer thin film containing a copper layer and a molybdenum layer, as obtained in Examples and Comparative Examples, was cut and observed with a 30000 magnification through scanning electronic microscope ("S5000H Type (Model Number)", by Hitachi) (acceleration voltage 2 kV, acceleration current 10 µA). On the thus-taken SEM image, the taper angle and the CD loss (µm) as shown in Fig. 1 were determined.

When the taper angle and the CD loss (µm) fell within the standard ranges shown in Table 1, the sample was considered to be acceptable for the etching performance.

### (Evaluation of etching residue)

A surface of a multilayer thin film sample having a copper layer and a molybdenum layer contained thereon after etching, as obtained in each of the Examples and Comparative Examples, was observed using a scanning electron microscope (S5000 Model (model number), manufactured by Hitachi, Ltd.) in an observation magnification of 50,000 times (accelerating voltage: 2 kV, accelerating current: 10 µA), and a residue of the sample was evaluated according to the following criteria.
A: A residue was not confirmed at all.
B: Though a residue was slightly confirmed, the wiring performance was not influenced, so that no problem was caused from the standpoint of practical use.
C: A remarkable residue was confirmed.

**Table 1**

| | Acceptable range |
|---|---|
| CD loss (= a) (µm) | Not more than 1 |
| Taper angle (°) | 30 to 60 |

### Fabrication Example (Fabrication of multilayer thin film having copper layer and molybdenum layer contained therein)

Molybdenum (Mo) was sputtered onto a substrate of glass to thereby form a barrier film of molybdenum (molybdenum layer) thereon, then a copper-based material was sputtered thereonto to form a wiring material film (copper layer), then a resist was applied onto it, a pattern mask was transferred through exposure thereonto, and developed to form a wiring pattern, thereby fabricating a multilayer thin film containing a copper layer and a molybdenum layer in which the copper layer was laminated on the molybdenum layer.

### Examples 1 to 5

The multilayer thin film having a copper layer and a molybdenum layer as obtained in the Fabrication Example was repeatedly subj ected to an operation of etching with an etching solution shown in Table 2 at 35 °C by means of shower spraying; and with respect to the obtained multilayer thin film having a copper layer and a molybdenum layer after etching, a taper angle and a CD loss (µm) were obtained in a low-concentration region of a copper ion concentration in the etching solution (also expressed as "Cu concentration") (from 200 to 1, 000 ppm; also expressed as "low Cu concentration region") and a high-concentration region of a copper ion concentration in the etching solution (from 3,000 to 4, 000 ppm; also expressed as "high Cu concentration region") by means of SEM observation.

Also, a time at which an etching subject of an area where the resist had not been patterned was determined to be etched by means of visual inspection was set up as a just etching time; and a time at which an etching treatment (overetching) was performed in an arbitrary proportion within the range of from 110 to 300 % of the just etching time was set up as an etching time (for example, when the just etching time is 100 seconds, so far as overetching of 50 % is concerned, its etching time is 150 seconds). These results of evaluations are shown in Table 2.

**Table 2**

| | | | Example | | | | |
|---|---|---|---|---|---|---|---|
| | | | 1 | 2 | 3 | 4 | 5 |
| Etching Solution | | | 1 | 2 | 3 | 4 | 5 |
| (A) | Hydrogen peroxide ^{*1} | (%by mass) | 5.8 | 5.8 | 5.8 | 5.8 | 4.5 |
| (B) | Nitric acid ^{*2} | (% by mass) | 0.07 | 0.07 | 0.07 | 1.63 | 0.05 |
| (C) | Succinic acid ^{*2} | (% by mass) | 3.0 | 3.0 | 3.0 | 3.0 | 3.0 |
| | Glycolic acid ^{*2} | (% by mass) | 2.0 | 2.0 | 2.0 | 2.0 | 2.0 |
| | Lactic acid ^{*2} | (% by mass) | 1.0 | 1.0 | - | 1.0 | 1.0 |
| | Malonic acid ^{*2} | (% by mass) | 2.0 | 3.0 | 3.5 | 0.5 | 2.0 |
| | Malic acid ^{*2} | (% by mass) | 2.0 | - | - | - | 2.0 |
| (D) | Ethanolamine ^{*2} | (% by mass) | - | - | - | - | - |
| | 1-Amino-2-propanol ^{*2} | (% by mass) | - | 2.8 | 2.8 | - | - |
| | N,N-Diethyl-1,3-propanediamine ^{*2} | (% by mass) | 4.0 | - | - | 4.9 | 5.5 |
| (E) | Azole ^{*3} | (% by mass) | 0.05 | 0.05 | 0.1 | 0.003 | 0.025 |
| (F) | Hydrogen peroxide stabilizer ^{*4} | (% by mass) | 0.1 | 0.1 | 0.1 | 0.1 | 0.1 |
| Water | | (% by mass) | Balance | Balance | Balance | Balance | Balance |
| pH | | | 3.5 | 3.0 | 3.0 | 3.9 | 4.0 |
| Cu film thickness/Mo film thickness | | angstrom/ angstrom | 3000/300 | 3000/300 | 3000/300 | 5000/200 | 3000/300 |
| Cu concentration at the time of evaluation (low-concentration region/high-concentration region) | | ppm | 1000/4000 | 1000/4000 | 1000/4000 | 1000/4000 | 500/3000 |
| Just etching time (low Cu concentration region/high Cu concentration region) | | sec | 83/65 | 63/61 | 62/70 | 82/86 | 98/85 |
| Etching time | | sec | 126 | 110 | 110 | 120 | 147 |
| Taper angle (low Cu concentration region/high Cu concentrabon region) | | degree | 35/50 | 30/40 | 30/40 | 40/30 | 35/50 |
| CD loss (low Cu concentration region/high Cu concentration region) | | µm | 0.75/0.79 | 1.0/0.84 | 0.82/0.64 | 0.92/0.92 | 0.82/0.74 |
| Overall evaluation of wiring cross-sectional shape | | | A | A | A | A | A |
| Evaluation of residue (low Cu concentration region/high Cu concentration region) | | | A/A | A/A | A/A | A/A | A/A |

| | | | | | | | |
|---|---|---|---|---|---|---|---|
| *1: Manufactured by Mitsubishi Gas Chemical Company, Inc. *2: Manufactured by Wako Pure Chemical Industries, Ltd. *3: 5-Amino-1H-tetrazole, manufactured by Wako Pure Chemical Industries, Ltd. *4: Phenylurea, manufactured by Wako Pure Chemical Industries, Ltd. | | | | | | | |

### Examples 6 and 7

As Examples 6 and 7, etching was performed in the same manner as that in Example 4, except that in Example 4, a copper powder was previously added in a copper ion concentration of 200 ppm and 6,000 ppm, respectively to the Etching Solution 4 to be used. A taper angle, a CD loss (µm), and evaluation of residue of the multilayer thin film having a copper layer and a molybdenum layer contained therein, as obtained in the first etching are shown in Table 3. Also, a taper angle, a CD loss (µm), and evaluation of residue of the multilayer thin film having a copper layer and a molybdenum layer of Example 4 as obtained in the first etching are shown in Table 3.

**Table 3**

| Example | | 4 (First etching) | 6 | 7 |
|---|---|---|---|---|
| Copper ion concentration | ppm | 0 | 200 | 6000 |
| Cu film thickness/Mo film thickness | angstrom/ angstrom | 5000/200 | 5000/200 | 5000/200 |
| Just etching time | sec | 80 | 80 | 101 |
| Etching time | sec | 120 | 120 | 120 |
| Taper angle | degree | 35 | 40 | 30 |
| CD loss | µm | 1.0 | 1.0 | 0.65 |
| Overall evaluation of wiring cross-sectional shape | | A | A | A |
| Evaluation of residue | | B | A | A |
| Evaluation of crystal deposition | | A | A | A |

### Comparative Examples 1 to 5

Samples were etched in the same manner as in Example 1, except that the etching solution comprising the components shown in Table 4 was used in Example 1. A taper angle, a CD loss (µm), and evaluation of residue of each of the obtained multilayer thin films having a copper layer and a molybdenum layer are shown in Table 4.

**Table 4**

| | | | Comparative Example | | | | |
|---|---|---|---|---|---|---|---|
| | | | 1 | 2 | 3 | 4 | 5 |
| Etching Solution | | | 6 | 7 | 8 | 9 | 10 |
| (A) | Hydrogen peroxide ^{*1} | (% by mass) | 5.8 | 6.0 | 6.0 | 5.8 | 5.8 |
| (B) | Nitric acid ^{*2} | (% by mass) | - | - | - | 0.07 | 0.07 |
| (C) | Succinic acid ^{*2} | (% by mass) | 3.0 | - | - | 3.0 | 3.0 |
| | Glycolic acid ^{*2} | (% by mass) | 2.0 | - | - | 2.0 | 2.0 |
| | Lactic acid ^{*2} | (% by mass) | - | - | - | 1.0 | 1.0 |
| | Malonic acid ^{*2} | (% by mass) | 2.0 | - | - | 3.0 | 3.0 |
| | Malic acid ^{*2} | (% by mass) | 2.0 | - | - | - | - |
| (D) | N,N-Diethyl-1,3-propanediamine ^{*2} | (% by mass) | 3.6 | - | - | - | - |
| | 1-Amino-2-propanol ^{*2} | (% by mass) | - | - | - | 2.8 | - |
| (E) | Azole ^{*3} | (% by mass) | 0.05 | - | - | 0.05 | 0.05 |
| (F) | Hydrogen peroxide stabilizer ^{*4} | (% by mass) | 0.1 | - | - | 0.1 | 0.1 |
| Ammonia | | (% by mass) | - | - | - | - | 1.0 |
| Sodium chloride | | (% by mass) | - | 5.0 | - | - | - |
| Potassium hydrogensulfate | | (% by mass) | - | - | 5.0 | - | - |
| Water | | (% by mass) | Balance | Balance | Balance | Balance | Balance |
| pH | | | 3.5 | 4.9 | 0.9 | 1.5 | 3.5 |
| Cu film thickness/Mo film thickness | | angstrom/ angstrom | 3000/300 | 3000/300 | 3000/300 | 3000/300 | 3000/300 |
| Cu concentration at the time of evaluation (low-concentration region/high-concentration region) | | ppm | 500/4000 | 0 | 0 | 1000/4000 | 1000/4000 |
| Just etching time (low Cu concentration region/high Cu concentration region) Etching time | | sec | 84/83 | 180 sec or more | 98 | 52/55 | 51/63 |
| | | sec | 126 | - | 150 | 130 | 130 |
| Taper angle (low Cu concentration region/high Cu concentration region) | | degree | 35/40 | - | - | 25/28 | Reversely tapered |
| CD loss (low Cu concentration region/high Cu concentration region) | | µm | 0.64/0.60 | - | - | 1.72/1.18 | 1.57/1.0 |
| Overall evaluation of wiring cross-sectional shape | | | C ^{*5} | C ^{*6} | C ^{*7} | C | C |
| Evaluation of residue (low Cu concentration region/high Cu concentration region) | | | B/A | - | - | B/A | A/A |

| | | | | | | | |
|---|---|---|---|---|---|---|---|
| *5: In the high Cu concentration region, in the wiring cross-sectional shape, undercut in which molybdenum as the lower layer was more selectively etched than copper as the upper layer was generated. *6: The etching was not achieved. *7: The resist was peeled. | | | | | | | |

The Examples using the etching solution of the present invention were favorable in the wiring cross-sectional shape after etching and also exhibited excellent results in view of the evaluation of residue. On the other hand, in Comparative Example 1 using an etching solution not containing the component (B), in the wiring cross-sectional shape, so-called undercut in which molybdenum as the lower layer was more selectively etched than copper as the upper layer was generated. In Comparative Examples 2 and 3 using an etching solution not containing the components (B) to (F), the etching did not proceed, or the resist was peeled, so that it was confirmed that these etching solutions cannot be put into practical use. Also, in Comparative Example 4 using an etching solution having a pH falling outside the range specified in the invention of the present application, the CD loss was large; and in Comparative Example 5 using an etching solution not containing the component (D), molybdenum as the lower layer was selectively etched, and the etched edge face was not formed in a forward tapered shape but a reversely tapered shape in which the taper angle partially exceeded 90°, so that it was confirmed that a problem was caused from the standpoint of wiring cross-sectional shape.

The wiring cross-sectional shape after first etching in Examples 6 and 7 using an etching solution previously containing 200 ppm and 6, 000 ppm of a copper ion, respectively was favorable as compared with the wiring cross-sectional shape after first etching in Example 4, so that it was confirmed that the evaluation of residue was favorable. That is, it was confirmed that when a copper ion is previously added in the etching solution of the present invention, a favorable performance is revealed from the beginning of use of the etching solution.

### INDUSTRIAL APPLICABILITY

The etching solution of the present invention can be favorably used for etching of a copper layer and a molybdenum layer contained therein; and according to the etching method of using the etching solution, a multilayer thin film containing a copper layer and a molybdenum layer can be etched all at a time to have a good wiring profile after etching, therefore realizing high producibility.

## Claims

1. An etching solution for a multilayer thin film having a copper layer and a molybdenum layer contained therein, which comprises (A) hydrogen peroxide, (B) a fluorine atom-free inorganic acid, (C) an organic acid, (D) an amine compound having a carbon number of from 2 to 10 and having an amino group and a hydroxyl group in a total group number of 2 or more, (E) an azole, and (F) a hydrogen peroxide stabilizer, and which has a pH of from 2.5 to 5,
wherein the fluorine atom-free inorganic acid (B) is at least one member selected among sulfuric acid, nitric acid, hydrochloric acid, phosphoric acid, hypophosphorous acid, carbonic acid, sulfamic acid and boric acid,
wherein the organic acid (C) is at least one member selected among succinic acid, glycolic acid, lactic acid, malonic acid, and malic acid,
wherein the azole (E) is at least one member selected among 1H-benzotriazole, 5-methyl-1H-benzotriazole, 3-amino-1H-triazole, 1H-tetrazole, 5-methyl-1H-tetrazole, 5-phenyl-1H-tetrazole, 5-amino-1H-tetrazole, 1H-imidazole, 1H-benzoimidazole, 1,3-thiazole and 4-methylthiazole and
wherein the hydrogen peroxide stabilizer (F) is at least one member selected among phenylurea, allylurea, 1,3-dimethylurea, thiourea, phenylacetamide and phenylethylene glycol.

2. The etching solution according to claim 1, wherein the amine compound (D) is at least one member selected among ethanolamine, 1-amino-2-propanol, and N,N-diethyl-1,3-propanediamine.

3. The etching solution according to claim 1 or 2, comprising from 4.5 to 7.5 % by mass of the hydrogen peroxide (A), from 0.01 to 3 % by mass of the inorganic acid (B), from 5 to 13 % by mass of the organic acid (C), from 2 to 7 % by mass of the amine compound (D), from 0.001 to 0.3 % by mass of the azole (E), and from 0.01 to 0.5 % by mass of the hydrogen peroxide stabilizer (F).

4. The etching solution according to any one of claims 1 to 3, further comprising from 100 to 2000 ppm of a copper ion in advance.

5. An etching method of a multilayer thin film having a copper layer and a molyb-denum layer contained therein, which comprises bringing an etching subject into contact with the etching solution according to any one of claims 1 to 4.

6. The etching method according to claim 5, wherein the multilayer thin film is one having a copper layer laminated on a molybdenum layer.

## Patentansprüche

1. Ätzlösung für einen mehrschichtige Dünnfilm mit einer darin enthaltenen Kupferschicht und Molybdänschicht, umfassend (A) Wasserstoffperoxid, (B) eine fluoratomfreie anorganische Säure, (C) eine organische Säure, (D) eine Aminverbindung mit einer Kohlenstoffzahl von 2 bis 10 und welche eine Aminogruppe und eine Hydroxygruppe in einer Gesamtzahl von 2 oder mehr aufweist, (E) ein Azol und (F) einen Wasserstoffperoxidstabilisator, und welche einen pH-Wert von 2,5 bis 5 aufweist,
wobei die fluoratomfreie anorganische Säure (B) mindestens ein Vertreter, ausgewählt aus Schwefelsäure, Salpetersäure, Salzsäure, Phosphorsäure, hypophosphoriger Säure, Kohlensäure, Amidosulfonsäure und Borsäure, ist,
wobei die organische Säure (C) mindestens ein Vertreter, ausgewählt aus Bernsteinsäure, Glykolsäure, Milchsäure, Malonsäure und Äpfelsäure, ist, wobei das Azol (E) mindestens ein Vertreter, ausgewählt aus 1H-Benzotriazol, 5-Methyl-1 H-benzotriazol, 3-Amino-1H-triazol, 1 H-Tetrazol, 5-Methyl-1 H-tetrazol, 5-Phenyl-1 H-tetrazol, 5-Amino-1H-tetrazol, 1 H-Imidazol, 1 H-Benzimidazol, 1,3-Thiazol, 4-Methylthiazol, ist, und
wobei der Wasserstoffperoxidstabilisator (F) mindestens ein Vertreter, ausgewählt aus Phenylharnstoff, Allylharnstoff, 1,3-Dimethylharnstoff, Thioharnstoff, Phenylacetamid und Phenylethylenglykol, ist.

2. Ätzlösung nach Anspruch 1, wobei die Aminverbindung (D) mindestens ein Vertreter, ausgewählt aus Ethanolamin, 1-Amino-2-propanol und N,N-Diethyl-1,3-propandiamin, ist.

3. Ätzlösung nach Anspruch 1 oder 2, umfassend von 4,5 bis 7,5 Massenprozent des Wasserstoffperoxids (A), von 0,01 bis 3 Massenprozent der anorganischen Säure (B), von 5 bis 13 Massenprozent der organischen Säure (C), von 2 bis 7 Massenprozent der Aminverbindung (D), von 0,001 bis 0,3 Massenprozent des Azols (E) und von 0,01 bis 0,5 Massenprozent des Wasserstoffperoxidstabilisators (F).

4. Ätzlösung nach einem der Ansprüche 1 bis 3, weiter vorab umfassend von 100 bis 2000 ppm eines Kupferions.

5. Ätzverfahren für einen mehrschichtige Dünnfilm mit einer darin enthaltenen Kupferschicht und Molybdänschicht, umfassend das Inkontaktbringen eines zu ätzenden Gegenstands mit der Ätzlösung nach einem der Ansprüche 1 bis 4.

6. Ätzverfahren nach Anspruch 5, wobei der mehrschichtige Dünnfilm eine Film ist, welcher eine Kupferschicht aufweist, die auf eine Molybdänschicht laminiert ist.

## Revendications

1. Solution de gravure pour un film mince multicouche contenant une couche de cuivre et une couche de molybdène, qui comprend (A) du peroxyde d'hydrogène, (B) un acide inorganique exempt d'atome de fluor, (C) un acide organique, (D) un composé amine ayant un nombre de carbones de 2 à 10 et ayant un groupe amino et un groupe hydroxyle dans un nombre total de groupes de 2 ou plus, (E) un azole, et (F) un stabilisateur de peroxyde d'hydrogène, et qui a un pH de 2,5 à 5,
dans laquelle l'acide inorganique exempt d'atome de fluor (B) est au moins un élément choisi parmi l'acide sulfurique, l'acide nitrique, l'acide chlorhydrique, l'acide phosphorique, l'acide hypophosphoreux, l'acide carbonique, l'acide sulfamique et l'acide borique,
dans laquelle l'acide organique (C) est au moins un élément choisi parmi l'acide succinique, l'acide glycolique, l'acide lactique, l'acide malonique et l'acide malique,
dans laquelle l'azole (E) est au moins un élément choisi parmi le 1H-benzotriazole, le 5-méthyl-1H-benzotriazole, le 3-amino-1H-triazole, le 1H-tétrazole, le 5-méthyl-1H-tétrazole, le 5-phényl-1H-tétrazole, le 5-amino-1H-tétrazole, le 1H-imidazole, le 1H-benzoïmidazole, le 1,3-thiazole et le 4-méthylthiazole et
dans laquelle le stabilisateur de peroxyde d'hydrogène (F) est au moins un élément choisi parmi la phénylurée, l'allylurée, la 1,3-diméthylurée, la thiourée, le phénylacétamide et le phényléthylène glycol.

2. Solution de gravure selon la revendication 1, dans laquelle le composé amine (D) est au moins un élément choisi parmi l'éthanolamine, le 1-amino-2-propanol et la N,N-diéthyl-1,3-propanediamine.

3. Solution de gravure selon la revendication 1 ou 2, comprenant de 4,5 à 7,5 % en masse du peroxyde d'hydrogène (A), de 0,01 à 3 % en masse de l'acide inorganique (B), de 5 à 13 % en masse de l'acide organique (C), de 2 à 7 % en masse du composé amine (D), de 0,001 à 0,3 % en masse de l'azole (E), et de 0,01 à 0,5 % en masse du stabilisateur de peroxyde d'hydrogène (F).

4. Solution de gravure selon l'une quelconque des revendications 1 à 3, comprenant en outre de 100 à 2 000 ppm d'un ion de cuivre à l'avance.

5. Procédé de gravure d'un film mince multicouche contenant une couche de cuivre et une couche de molybdène, qui comprend la mise en contact d'un objet de gravure avec la solution de gravure selon l'une quelconque des revendications 1 à 4.

6. Procédé de gravure selon la revendication 5, dans lequel le film mince multicouche est un film ayant une couche de cuivre stratifiée sur une couche de molybdène.
